Europäisches Patentamt

European Patent Office

Office européen des brevets

(11) Publication number: 0 310 047 A2

# (12) EUROPEAN PATENT APPLICATION

(21) Application number: 88116031.1

(22) Date of filing: 28.09.88

(51) Int. Cl.4: H01L 29/78 , H01L 29/06

(30) Priority: 30.09.87 JP 246013/87

(43) Date of publication of application:
05.04.89 Bulletin 89/14

(84) Designated Contracting States:
DE FR GB IT

(71) Applicant: KABUSHIKI KAISHA TOSHIBA
72, Horikawa-cho Saiwai-ku
Kawasaki-shi Kanagawa-ken 210(JP)

(72) Inventor: Suzuki, Kazuaki
c/o Patent Division Kabushiki Kaisha
Toshiba
1-1 Shibaura 1-chome Minato-ku Tokyo
105(JP)

(74) Representative: Henkel, Feiler, Hänzel &
Partner
Möhlstrasse 37
D-8000 München 80(DE)

(54) Double-diffused mos fet.

(57) A plurality of p-type low-resistance regions (23) are formed on a surface of an n-type semiconductor substrate so as to suppress operations of parasitic bipolar transistors, and p-type channel base regions (24) are formed so as to surround the low-resistance regions (23), respectively. Each low-resistance region (23) has a periphery substantially square in shape, with rounded four corners and corresponding in what respect to that of each channel base region, so that the distance from the periphery of the low-resistance region (23) to that of the channel base region (24) is set to be constant.

F I G. 7

## Double-diffused MOS FET

The present invention relates to a double-diffused MOS FET used mainly for power control.

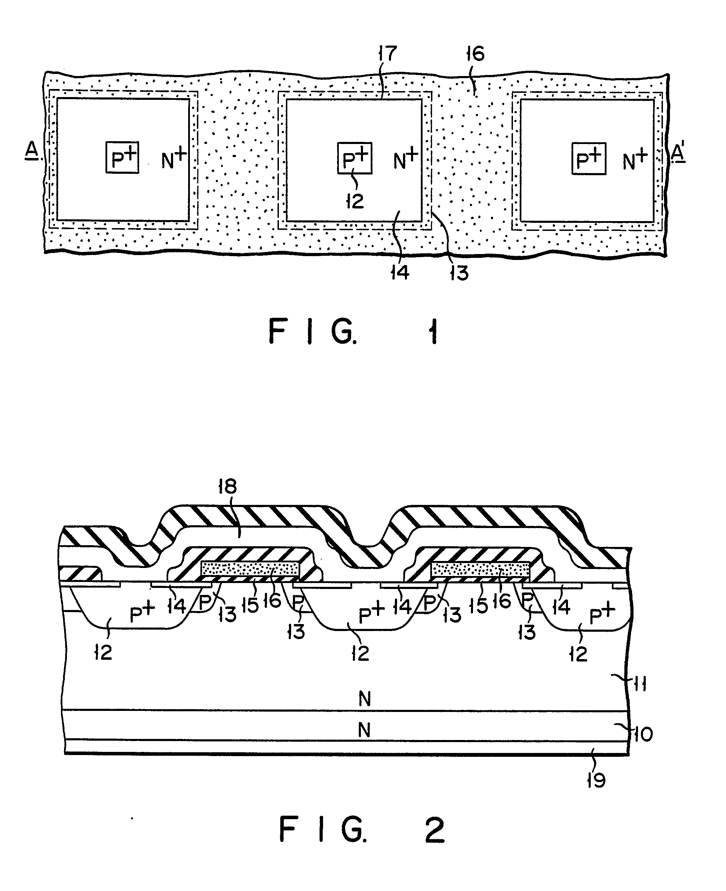

A double-diffused MOS FET (D-MOS) is generally used for power control, and is constituted by a plurality of unit FET cells connected in parallel. Fig. 1 is a plan view showing an arrangement of a conventional D-MOS comprising unit FET cells each having a square top surface, and Fig. 2 is a sectional view taken along line A - A′ of Fig. 1.

Referring to Fig. 1, low-concentration n-type epitaxial layer 11 is deposited on a surface of high-concentration n-type silicon substrate 10. Substrate 10 and epitaxial layer 11 together constitute a drain region of each unit FET cell. $P^+$-type low-resistance regions 12 are formed separately at a plurality of positions on the surface of epitaxial layer 11, and p-type channel base regions 13 are respectively formed around regions 12. $N^+$-type source region 14 is continuously formed on the surfaces of each low-resistance region 12 and each channel base region 13. A gate electrode 16 is formed on the surface of each channel base region 13, through gate insulating layer 15, and is patterned in the form of a mesh constituted by a plurality of square openings 17. The respective unit FET cells are formed near corresponding openings 17. Note that reference numeral 18 denotes a source electrode which is connected to each of low-resistance regions 12 and source regions 14, and which is common to all the unit FET cells. In addition, drain electrode 19 is connected to the other surface of substrate 10.

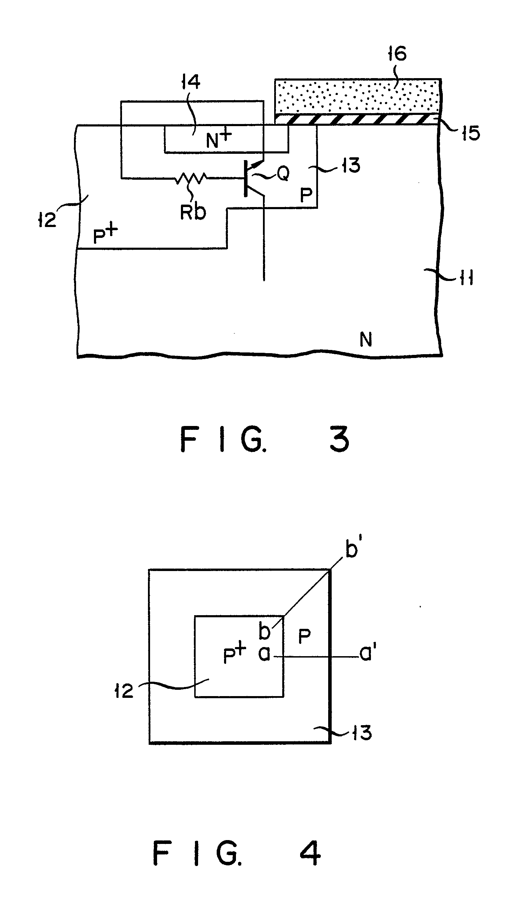

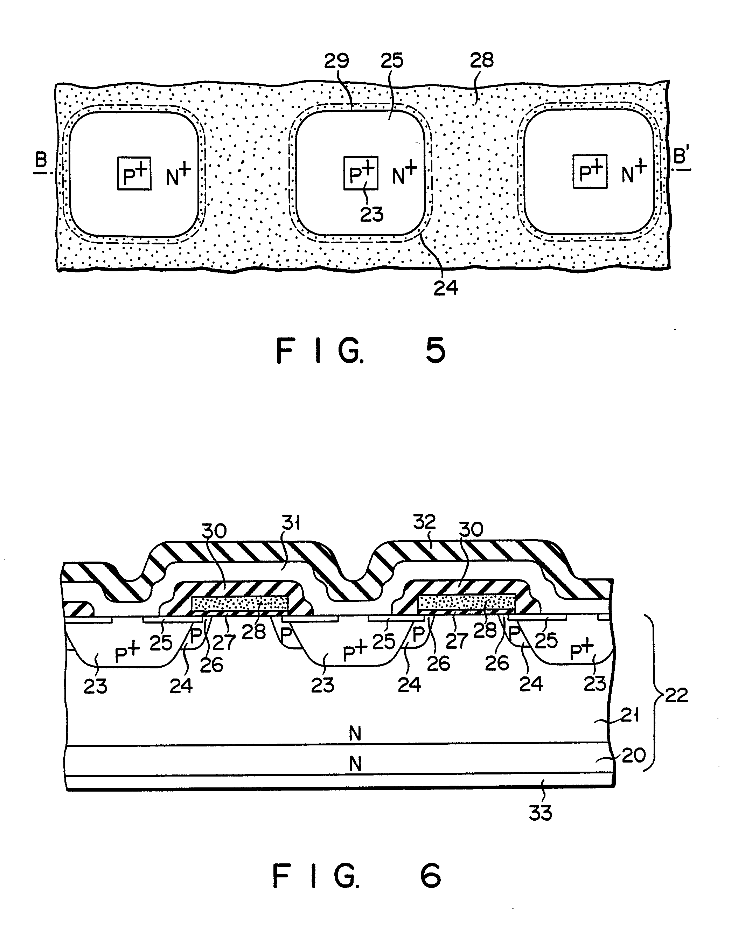

In the D-MOS having such an arrangement, as shown in the sectional view of Fig. 3, npn bipolar transistor Q constituted by n-type epitaxial region 11 as a collector, p-type channel base region 12 as a base, and source region 14 as an emitter is parasitically generated. Furthermore, parasitic resistance Rb due to a diffusion resistance in low-concentration channel base region 13 is formed between the base and emitter of transistor Q.

When a D-MOS is used to control an inductive load, a high voltage is generated upon switching of the D-MOS and causes the above-described parasitic transistor Q to be partially operated, with the result that a large current flows between the source and the drain. As a result, the D-MOS may be destroyed. For this reason, in the conventional D-MOS, the value of resistance Rb is decreased by forming above low-resistance region 12 so that parasitic transistor Q cannot be easily rendered conductive.

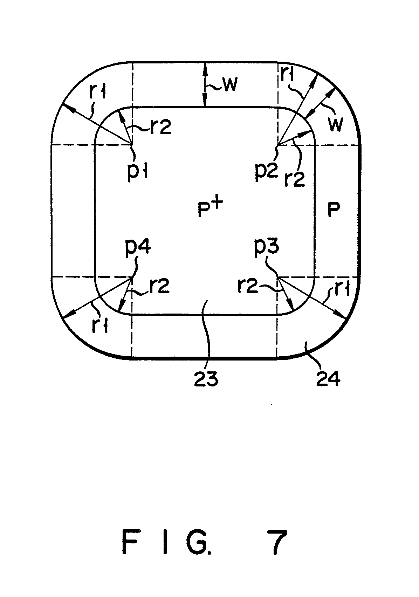

However, as is shown in the plan view of Fig. 4, low-resistance region 12 and channel base region 13 are respectively formed into square patterns. Being formed in this manner, the distance between the peripheries of region 12 and channel base region 13 which is located outward therefrom, is quite large at the respective corners of the unit FET cell. As a result, the value of parasitic resistance Rb varies depending on positions in the unit FET cell. For example, the distance from the periphery of low-resistance region 12 to that of channel base region 13, located outward therefrom, becomes relatively small at a position along line a - a′ in Fig. 4. For this reason, the value of parasitic resistance Rb at this position becomes relatively small. In contrast to this, the distance from the periphery of low-resistance region 12 to that of channel base region 13 located outward therefrom becomes relatively large at a position along line b - b′ in Fig. 4. For this reason, the value of parasitic resistance Rb at a position along line b - b′ is increased with an increase in distance across channel base region 13.

In the conventional D-MOS, parasitic bipolar transistors which are easily turned on at the corners of each unit FET. Therefore, when an inductive load is to be driven, whether the D-MOS itself is destroyed or not is determined by the parasitic bipolar transistors which are generated at the corners and easily turned on.

The present invention has been developed in consideration of the above situation, and has as its object to provide a double-diffused MOS FET has good resistance to destruction caused when a parasitic bipolar transistor is rendered conductive.

According to the present invention, there is provided a double-diffused MOS FET comprising a semiconductor substrate having parallel first and second planar surfaces and doped with an impurity of a first conductivity type, a plurality of first semiconductor regions of a second conductivity type, diffused in the form of a mesh in the first planar surface of the substrate, each of the first semiconductor regions having a substantially square periphery with four rounded corners, a plurality of second semiconductor regions of the second conductivity type, each of which is diffused so as to surround a corresponding one of the first semiconductor regions, has a depth less than that of the first semiconductor region, and has a periphery the shape of which corresponds to that of the first semiconductor region, the planar distance from the periphery of each of the first second semiconductor regions to that of a corresponding one of the first semiconductor regions being set to be equal throughout the periphery of each of the first semiconductor regions, a plurality of source regions of the first conductivity type, which are diffused in the plurality of first and second semiconductor regions on the first planar surface and are shallower than the first and second semiconductor regions, the periphery of each of the source regions being located a predetermined distance inward from that of a corresponding one of the second semiconductor regions, a plurality of channel regions constituted by the second semiconductor regions respectively defined between the peripheries of the source and second semiconductor regions, a gate insulating layer extending in the form of a mesh between the first and second semiconductor regions, so as to surround the first and second semiconductor regions and cover the plurality of channel regions, a gate electrode deposited in the form of a mesh on the gate insulating layer, a common source electrode connected to the plurality of source and first semiconductor regions and extending on the first planar surface, and a drain electrode connected to the second planar surface of the substrate.

This invention can be more fully understood from the following detailed description when taken in conjunction with the accompanying drawings, in which:

Fig. 1 is a plan view showing a pattern of a conventional double-diffused MOS FET;

Fig. 2 is a sectional view taken along line A - A' of Fig. 1;

Fig. 3 is a schematic sectional view showing an enlarged portion of the sectional view of Fig. 2;

Fig. 4 is a partial plan view of the pattern shown in Fig. 1;

Fig. 5 is a plan view showing a pattern of a MOS FET according to an embodiment of the present invention;

Fig. 6 is a sectional view taken along line B - B' of Fig. 5; and

Fig. 7 is a partial view of the pattern shown in Fig. 5.

A case wherein the present invention is applied to an n-channel D-MOS will be described below with reference to Figs. 5 and 6.

Reference numeral 20 denotes a silicon semiconductor layer. Antimony or arsenic is doped as an n-type impurity in semiconductor layer 20, at a concentration of, for example, about $1 \times 10^{18}$ to $1 \times 10^{20}$ (/cm$^3$). N-type epitaxial layer 21, which is doped with phosphorus as an n-type impurity at a relatively high concentration, e.g., about $1 \times 10^{15}$ - ('cm$^3$), is formed on one surface of semiconductor layer 20. Semiconductor layer 20 and epitaxial layer 21 constitute n-type substrate 22. Semiconductor layer 20 and epitaxial layer 21 serve as a drain for a plurality of unit FETs to be described later.

P$^+$-type low-resistance regions 23 are formed separately in a plurality of portions of the exposed surface of n-type epitaxial layer 21, and are doped with boron, as a p-type impurity, is doped at a surface concentration of about $1 \times 10^{20}$ (/cm$^3$). Low-resistance regions 23 are formed on the exposed surface of n-type epitaxial layer 21 in the form of a mesh, as shown in Fig. 5. P-type channel base regions 24 each having a depth less than that of each low-resistance region 23 are respectively formed around low-resistance regions 23. Boron as a p-type impurity is doped in each channel base region 24 at a surface concentration of about $1 . 10^{17}$ (/cm$^3$). A plurality of n-type source regions 25 each having a depth smaller than that of each channel base region 24 are continuously formed on the surfaces of low-resistance regions 23 and channel base regions 24, respectively. Each source region 25 is formed such that its periphery is located inward from that of a corresponding channel base region 24 while a predetermined distance is kept between these peripheries. Surface region 26 of channel base region 24, which is present between the peripheries of each source region 25 and corresponding channel base region 24, is defined as a channel region of each unit FET cell. Therefore, channel regions 26 of the unit FET cells are formed so as to surround corresponding channel base regions 24.

Gate insulating layer 27 consisting of silicon oxide is deposited in the form of a mesh so as to surround channel base regions 24 and low-resistance regions 23 and cover channel regions 26 described above. In addition, gate electrode 28 consisting of polysilicon and having the same shape as that of gate insulating layer 27 is deposited on gate insulating layer 27. As shown in Fig. 5, gate insulating layer 27 and gate electrode 28 formed into the same shape are patterned in the form of a mesh constituted by a plurality of substantially square openings 29 each having rounded four corners. A plurality of unit FET cells each constituted by n-type silicon semiconductor and n-type epitaxial layers 20 and 21 as a drain, channel base region 24 as a base, and source region 25 as a source are formed near openings 29. Insulating interlayer 30 is deposited on gate electrode 28. Source electrode 31 consisting of aluminum is integrally formed on the exposed surfaces of low-resistance regions 23 and source regions 25, so that all source regions 25 are connected to source electrode 31. In addition, surface protective layer 32 consisting of silicon oxide or silicon nitride is deposited on source electrode 31 by CVD. Drain electrode 33 consisting of aluminum is formed on the exposed surface of n-type silicon semiconductor layer 20. Note that each low-resistance region 23 is formed so as to decrease the value of parasitic resistance Rb due to a diffusion resistance between the base and the emitter of parasitic bipolar transistor Q.

Channel base region 24 is formed by p-type impurity diffusion using gate electrode 28 as a mask. Furthermore, low-resistance region 23 is formed into a shape similar to opening 29. Low-resistance regions 23 are formed by p-type impurity diffusion using a mask (not shown) for impurity diffusion, which has a plurality of openings smaller than openings 29. Then, the mask which is used for forming low-resistance regions 23 is removed.

Fig. 7 is a plan view showing a pattern of channel base region 24 and low-resistance region 23 of one unit FET in the D-MOS of the above embodiment. As shown in Fig. 7, the peripheries of low-resistance region 23 and channel base region 24 are formed into substantially square shapes similar to each other. The four corners of regions 23 and 24 respectively constitute parts of concentrical circles respectively defined by radii r1 and r2, and points p1, p2, p3, and p4 as the centers. Distance W from the periphery of low-resistance region 23 to that of channel base region 24 is set to be constant at any positions. With this arrangement, in the D-MOS of this embodiment, the value of parasitic resistance Rb between the base and the emitter of the bipolar transistor corresponding to parasitic bipolar transistor Q shown in Fig. 3 is set to be constant at any positions in each unit FET. As a result, the parasitic transistors are turned on in the same manner at any positions in each unit FET, thus solving the problem that only some of the transistors are easily rendered conductive as in the conventional D-MOS. As a result, the D-MOS of this embodiment has good resistance to destruction caused when an inductive load is driven.

In addition, the D-MOS of this embodiment can be manufactured by only changing the shape of mask pattern for diffusion without specifically adding complex manufacturing processes.

## Claims

1. A double-diffused MOS FET comprising:
a semiconductor substrate (22) having parallel first and second planar surfaces and doped with an impurity of a first conductivity type;
a plurality of first semiconductor regions (23) of a second conductivity type diffused in the form of a mesh in the first planar surface of said substrate, each of said first semiconductor regions having a substantially square periphery with rounded four corners;
a plurality of second semiconductor regions (24) of the second conductivity type, each of which is diffused to surround a corresponding one of said first semiconductor regions, has a depth less than that of said first semiconductor region, and has a periphery of a shape which corresponds to that of said first semiconductor region, a planar distance from the periphery of each of said first second semiconductor regions to that of a corresponding one of said first semiconductor regions being set to be equal throughout the periphery of each of said first semiconductor regions;
a plurality of source regions (25) of the first conductivity type, which are diffused in said plurality of first and second semiconductor regions on the first planar surface and are shallower than said first and second semiconductor regions, a periphery of each of said source regions being located a predetermined distance inward from that of a corresponding one of said second semiconductor regions;
a plurality of channel regions (26) constituted by said second semiconductor regions respectively defined between the peripheries of said source and second semiconductor regions;
a gate insulating layer (27) in the form of a mesh extending between said first and second semiconductor regions to surround said first and second semiconductor regions and to cover said plurality of channel regions;
a gate electrode (28) deposited in the form of a mesh on said gate insulating layer;
a common source electrode (31) connected to said plurality of source and first semiconductor regions, and extending on the first planar surface; and
a drain electrode (33) connected to the second planar surface of said substrate.

2. An FET according to claim 1, characterized in that an impurity concentration of each of said first semiconductor regions (23) is set to be higher than that of each of said second semiconductor regions (24).

3. An FET according to claim 1, characterized in that said gate insulating layer (27) consists of an oxide and said gate electrode (28) consists of polysilicon.

F I G. 1

F I G. 2

F I G. 3

F I G. 4

F I G. 5

F I G. 6

F I G. 7